# EUROPEAN PATENT APPLICATION

(11) **EP 0 986 107 A1**
(43) Date of publication of application: **15.03.2000**
(21) Application number: 98830523.1
(22) Date of filing: 08.09.1998
(51) Int. Cl.: H01L 27/115, H01L 21/8247

(54) **Cell array structure for an electrically erasable and programmable non-volatile memory device**

(71) Applicant: STMicroelectronics S.r.l., 20041 Agrate Brianza (Milano) (IT)
(72) Inventor: Vajana, Bruno, 24100 Bergamo (IT); Dalla Libera, Giovanna, 20052 Monza (Milano) (IT)
(74) Representative: Mittler, Enrico

(57) **Abstract**

Cell array structure for an electrically erasable and programmable non-volatile memory device comprising an array of memory cells (1,2) arranged in rows (WLₖ,WLₖ₊₁) and columns (BLᵢ,BLᵢ₊₁) and grouped together in groups to form individually readable, programmable and erasable memory locations (BY1,BY2), each memory location having a respective control electrode (CGa,CGb) common to all the memory cells of the memory location. Conductor lines (100a,100b) directly contacting respective control electrodes of the memory locations are provided for externally selecting the control electrodes of the memory locations.

## Description

The present invention concerns electrically erasable and programmable non-volatile memory devices, particularly EEPROM memories. More specifically, the invention relates to a cell array structure for such devices.

The market demand for EEPROM devices with large storage capacity, i.e. ≥ 256 Kbit, is known. This requires efforts towards the reduction of the chip area.

As known, EEPROMs are arranged per bytes or per words. This arrangement makes it possible to modify the memory content on a per-byte or, respectively, per-word basis, a feature that makes EEPROMs particularly useful in some applications if compared to, e.g., EPROMs and Flash EEPROMs, which are instead bulk-erasable devices.

This feature is achieved thanks to the fact that the control gate of each single memory byte or word in the memory cell array is physically distinct from the control gates of the other memory bytes or words, and can be individually addressed in writing, erasing and reading, by the provision of a respective byte- or word-select transistor, generally called "byte switch". Obviously, this feature has a counterpart that the single EEPROM memory byte or word occupies more chip area compared to, e.g., EPROM or Flash EEPROM memory bytes or words.

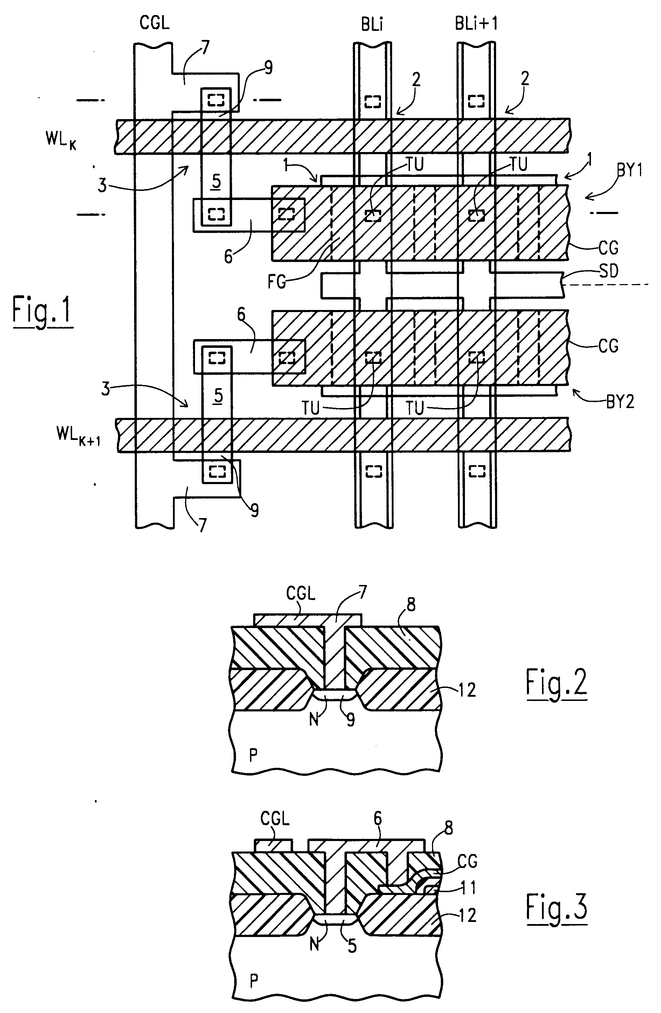

To better comprehend the state of the art, reference is made to Figure 1, showing a portion of a conventional EEPROM memory cell array. The array portion depicted in Figure 1 relates to two memory bytes BY1, BY2 (in general, two memory locations of the memory device). Each byte is connected to a respective control gate line CGL, made of aluminum. Each memory cell of the byte comprises a conventional floating-gate tunnel-oxide MOS transistor 1 in series to a select MOS transistor 2. The drain electrode of the select transistor 2 is connected to a respective bit line BLᵢ, BLᵢ₊₁, also made of aluminum and normally obtained from a same aluminum layer as the control gate line CGL. The gate electrodes of the select transistors 2 of all the memory cells of a same byte are connected to a same word line WLₖ, WLₖ₊₁, made of polysilicon. The source electrodes of the floating-gate transistors 1 of all the memory cells of a same byte are connected together by a source diffusion SD. The control gate electrodes of the floating-gate transistors 1 of all the memory cells of a same byte are connected to a common byte control gate CG made of polysilicon and normally obtained from a same polysilicon layer as the word lines WLₖ, WLₖ₊₁. The byte control gate CG, through a respective byte-switch 3, is in turn connected to a respective control gate line CGL. The byte-switch 3 typically comprises a MOS transistor having a drain electrode electrically coupled to the control gate line CGL, a gate electrode electrically coupled to a respective word line WLₖ, WLₖ₊₁, and a source electrode electrically coupled to the byte control gate CG.

Conventionally, selection circuits for selecting the word lines WLₖ, WLₖ₊₁, the control gate lines CGL and the bit lines BLᵢ, BLᵢ₊₁ are provided externally to the memory cell array.

Selection of a memory byte, such as BY1, is achieved by biasing the respective control gate line CGL, biasing the respective word line WLₖ, and biasing the respective bit lines BLᵢ, BLᵢ₊₁···. In this way, through the byte-switch 3 which is turned on by the voltage on the word line WLₖ, the voltage on the control gate line CGL is transferred to the byte control gate CG and thus to the control gate electrodes of the floating-gate transistors 1. The voltage put on the word line WLₖ also activates the select transistors 2 of the memory cells of the byte. Consequently, the drain electrodes of the floating-gate transistors 1 are connected to the respective bit lines BLᵢ, BLᵢ₊₁ ···. The other bytes connected to the same control gate line CGL line are not affected, since they are connected to a different word line (e.g., byte BY2 is connected to WL_{k+1,} which is not activated). The other bytes connected to the same word line are also not affected, since they are connected to control gate lines different from control gate line CGL. Thus, only one byte at a time is effectively addressed.

Referring now also to Figures 2 and 3, the aluminum control gate lines CGL have lateral extensions 7 which, through contact openings in a dielectric layer 8, contact an underlying N type diffusion 9 forming the drain electrode of the byte-switch MOS transistor 3. Electrical connection between a source electrode N type diffusion 5 of the byte-switch MOS transistor 3 and the respective polysilicon byte control gate CG is achieved by means of an aluminum jumper 6 which, through contact openings in the dielectric layer 8, contacts the source electrode diffusion 5 and the polysilicon byte control gate CG, short-circuiting them. The byte control gate CG is formed out of an upper polysilicon level, a lower polysilicon level 11 being used for forming the floating gates FG of the floating-gate transistors 1. For each floating-gate transistor 1, under the floating gate FG a tunnel oxide area TU is provided. Conventionally, thick field oxide areas 12 separates the active areas of the chip.

Since both the control gate lines CGL and the jumpers 6 are formed out of a same aluminum layer, the distance between them must be sufficient for preventing shorts between the control gate lines CGL and the jumpers 6. It is for this reason that the control gate lines CGL must be provided with the lateral extensions 7.

It appears clearly that the provision of the byte-switches determines an overhead in the area dedicated to the memory cell array. However, such an overhead cannot be prevented, if the feature of byte or word individual selection is to be maintained. Another fact to be considered is that each byte-switch must be located adjacent to the respective byte, in other words, the byte-switches are integral to the memory cell array.

In view of the state of the art described, it has been an object of the present invention that of providing a cell array structure for an electrically erasable and programmable non-volatile memory device allowing in the first place for a reduction of the memory cell array area.

According to the present invention, such an object has been achieved by means of a cell array structure for an electrically erasable and programmable non-volatile memory device comprising an array of memory cells arranged in rows and columns and grouped together in groups to form individually readable, programmable and erasable memory locations, each memory location having a respective control electrode common to all the memory cells of the memory location, characterized by comprising conductor lines directly contacting respective control electrodes of the memory locations for externally selecting the control electrodes of the memory locations.

The features and advantages of the present invention will be made apparent by the following detailed description of a particular embodiment thereof, shown by way of a non-limiting example in the annexed drawings, wherein:
Figure 1 shows in top-plan view a portion of a conventional cell array structure for an electrically erasable and programmable non-volatile memory device;
Figures 2 and 3 respectively show cross-sections along lines II-II and III-III of Figure 1;
Figure 4 shows in top-plan view a portion of a cell array structure according to the present invention.

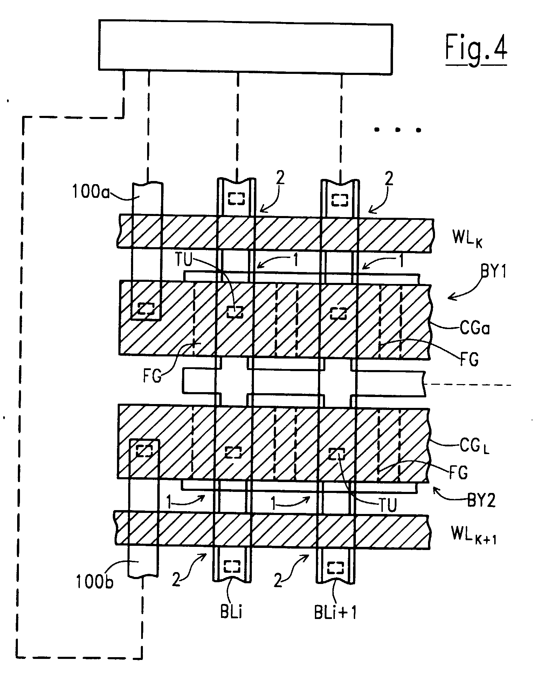

Referring to Figure 4, a cell array structure according to the present invention for an electrically erasable and programmable memory device comprises, as the conventional one depicted in Figure 1, an array of memory cells arranged in rows and columns. The memory cells are grouped to form memory bytes BY1, BY2 or, more generally, individual memory locations of the memory device, the memory bytes or memory locations being individually addressable for reading, programming and erasing.

As in the conventional cell array structures, each memory cell comprises a floating gate MOS transistor 1 connected in series to a respective selection transistor 2. A drain electrode of the selection transistor 2 of each memory cell is connected to a respective bit line BLᵢ, BLᵢ₊₁,···, made from a metal (e.g., aluminum) layer, a gate electrode of all the selection transistors 2 of the memory cells of a same byte are connected to a same respective word line WLₖ, WLₖ₊₁, a source electrode of the selection transistor 2 of each memory cell is connected to the drain electrode of the respective floating-gate MOS transistor 1. The floating-gate MOS transistors 1 are per-se conventional, and comprises a floating gate FG made from a lower polysilicon layer, under which a tunnel oxide area TU is provided. All the floating-gate MOS transistors 1 of a same memory byte BY1, BY2 have their control gate electrodes connected together by a respective polysilicon byte control gate CGa, CGb made from an upper polysilicon layer, namely the same polysilicon layer as the word lines.

The difference between the conventional cell array structure and the cell array structure according to the present invention resides in that no byte-switches are provided, but nonetheless the same possibility of individually addressing the memory bytes for reading, programming and erasing is maintained.

This is achieved by providing in the cell array structure conductor lines 100a, 100b extending substantially parallelly to the bit lines and directly contacting the byte control gate CGa, CGb of each memory byte by one respective conductor line 100a, 100b.

Selection of a memory byte, e.g. BY1, is achieved by selecting the respective conductor line 100a, selecting the respective bit line BLᵢ, BLᵢ₊₁···, and selecting the respective word line WLₖ.

The conductor lines 100a, 100b can be made from a metal layer, e.g. an aluminum layer. This metal layer can be the same metal layer from which also the bit line BLᵢ, BLᵢ₊₁··· are formed, provided that the conductor lines 100a, 100b do not cross other conductor lines made from the same metal layer. So, the cell array structure of the invention does not necessarily require the provision of an additional metal layer. In cases where such a crossing cannot be avoided, then an additional metal layer for the conductor lines 100a, 100b is to be provided.

Thanks to the fact that the byte-switches are eliminated, the dimensions of each single byte are consequently reduced compared to the conventional structures. The overall dimension of the memory device is therefore reduced.

Also, the elimination of the byte-switch improves the device's reliability, since as known the byte-switch MOS transistors 3 are normally highly critical because they have to sustain the high programming and erase voltages.

Furthermore, in this way it is possible to better control the programming voltage really applied to the byte control gate of the memory byte to be programmed, and it is also possible to apply to the byte control gate a lower voltage in erasing than in programming.

## Claims

1. Cell array structure for an electrically erasable and programmable non-volatile memory device comprising an array of memory cells (1,2) arranged in rows (WLₖ,WLₖ₊₁) and columns (BLᵢ,BLᵢ₊₁) and grouped together in groups to form individually readable, programmable and erasable memory locations (BY1,BY2), each memory location having a respective control electrode (CGa,CGb) common to all the memory cells of the memory location, characterized by comprising conductor lines (100a,100b) directly contacting respective control electrodes of the memory locations for externally selecting the control electrodes of the memory locations.

2. Cell array structure according to claim 1, characterized in that said conductor lines (100a,100b) are formed from a metal layer.

3. Cell array structure according to claim 2, characterized in that said metal layer from which the conductor lines (100a,100b) are formed is the same metal layer from which the columns (BLᵢ,BLᵢ₊₁) are also formed.

4. Cell array structure according to claim 2, characterized in that said metal layer from which the conductor lines (100a,100b) are formed is a dedicated metal layer provided in addition to a metal layer from which the columns (BLᵢ,BLᵢ₊₁) are formed.
